# EUROPEAN PATENT SPECIFICATION

(11) **EP 3 706 265 B1**
(45) Date of publication and mention of the grant of the patent: **27.10.2021**
(21) Application number: 19161298.5
(22) Date of filing: 07.03.2019
(51) Int. Cl.: H02B 1/30

(54) **METHOD FOR MOUNTING A PANEL TO AN ELECTRICAL CABINET AND SUCH CABINET**
VERFAHREN ZUR MONTAGE EINES PANEELS AN EINEM SCHALTSCHRANK UND SOLCHER SCHALTSCHRANK
PROCÉDÉ DE MONTAGE D'UN PANNEAU SUR UNE ARMOIRE ÉLECTRIQUE ET UNE TELLE ARMOIRE

(43) Date of publication of application: 09.09.2020
(73) Proprietor: ELDON Group, 28223 Madrid (ES)
(72) Inventor: RAMOS, David, 28050 Madrid (ES)
(74) Representative: Grünecker Patent- und Rechtsanwälte PartG mbB

(56) References cited:
- EP-A2- 0 825 697
- US-A- 5 759 002
- US-B1- 7 014 155

## Description

This invention relates generally to a method according to the preamble of claim 1 for mounting a panel to a wiring cabinet using at least one fastening element. The wiring cabinet comprises at least one frame profile. The panel has an upper end and a lower end, and also has a rear surface and a front surface.

The method comprises a step of attaching the panel to the wiring cabinet into a premounted state, wherein the rear surface of the panel is in contact with the frame profile.

The method further comprises a step of fastening the panel to the wiring cabinet by means of the fastening element, wherein the fastening element is inserted through an opening in the panel and an opening in the frame profile, and wherein the panel is held to the frame profile by the engagement of the fastening element with the frame profile, wherein the fastening element comprises an expanding rivet with an opening, and further comprises an expanding body, wherein the expanding rivet has at least two rivet legs. The step of fastening the panel comprises a step of inserting the expanding rivet in an insertion direction through the opening in the panel and the opening in the frame profile, and further comprises a step of inserting the expanding body into the opening of the expanding rivet so that the rivet legs are forced apart in such a way, that the rivet legs engage the frame profile..

US 2,899,254 A discloses a method for fastening a panel to a wiring cabinet. In the method described there, the fastening element is formed by a rivet in particular. The use of a rivet for mounting a panel to the wiring cabinet causes the panel to be undetachable from the wiring cabinet.

EP 0 825 697 A2 and US 5 759 002 A disclose methods according to the preamble of the independent claim 1.

In further prior art the panel is mounted to the wiring cabinet by means of a screw, wherein the screw is retained by a clip nut or a cage nut. The nut is thereby substantially on the rear side of the frame profile, and therefore has to be mounted to the frame profile in advance of attaching the panel. Methods of this type involve a series of laborious assembly steps, as all nuts required for mounting a panel are required to be in the precise location on the frame profile. The commonly used rows of holes in the frame profiles thereby impede the proper alignment of the nuts with the corresponding openings in the panel in advance of attaching the panel. The present invention's object is to provide a timesaving method for easily mounting a panel to a wiring cabinet, so that the panel can be easily fastened from the front side.

This object is accomplished by the features of the independent claim 1. Accordingly, in the case of a method according to the preamble of the independent claim 1, an inventive solution to the object exists, if the expanding rivet has at least one second protrusion, which protrudes radially from the expanding rivet. After insertion of the expanding rivet through the opening in the panel and rotation around a rotational axis of the expanding rivet the second protrusion sits below the panel.

The present invention allows an easier way of assembling and disassembling a panel to a wiring cabinet. The expanding rivet is directly inserted through the opening in the panel and is thereby automatically in alignment with the corresponding opening in the frame profile. By removing the expanding body, the rivet legs can be retracted, thereby simplifying the disassembly of the panel from the wiring cabinet. Due to the second protrusion the expanding rivet is retained to the panel in the direction opposite to the insertion direction even in an unfastened state by the second protrusion from the rear side of the panel, simplifying the assembly of the panel.

Advantageous embodiments of this invention are subject of the subclaims.

Preferably, the expanding rivet is being inserted from the front surface of the panel. This further simplifies the assembly process for the panel, as all components and elements for fastening the panel are accessible from the front surface of the panel. In a particularly preferred embodiment, the expanding body is inserted from the front surface of the panel as well.

Preferably, the expanding body is a screw. The utilisation of a screw has the advantage that the expanding rivet can be more easily unfastened by unscrewing the screw and thereby retracting the rivet legs, so that they no longer engage the frame profile.

Preferably, attaching the panel to the wiring cabinet comprises suspending the panel at its upper end from a horizontal frame element in such a way that the panel in a premounted state is pivotable about an axis parallel to the horizontal frame element. In a particularly preferred embodiment, the panel has at least a first fold at its upper end, wherein the horizontal frame profile has at least a second fold, wherein the first and second fold interact as tilting mechanism, so that in a premounted state the panel is pivotable about the connection between the first and second fold. This has the advantage, that weight of the panel is supported by the frame of the wiring cabinet during the assembly of the panel, facilitating its mounting process.

Preferably, the expanding rivet is substantially round.

Preferably, the expanding rivet has a collar that radially protrudes beyond the circumference derived from the rivet legs. This collar sits on top of the front surface of the panel, when the expanding rivet is inserted through the opening in the panel and retains the expanding rivet to the panel in the insertion direction. This way the position of the rivet legs with respect to the panel and the frame profile can be specified and the assembly is facilitated.

Preferably, the opening in the panel and the expanding rivet are formed in such a way, that after insertion, the expanding rivet is held in a nonrotatable manner relative to the panel. Thus, the direction of the expansion of the rivet legs can be defined, whereby a particularly good retention of the expanding rivet on the frame profile can be achieved.

Preferably, the expanding rivet has at least one radial first protrusion, wherein the first protrusion interacts with the opening of the panel in such a way that after insertion, the expanding rivet is held in a nonrotatable manner relative to the panel. This allows the orientation of the expanding rivet towards the panel to be defined more precisely.

Preferably, the position of the radial first protrusion and radial second protrusion is in a way that an angle between the circumferential position of the first protrusion and the position of the second protrusion in regard to the rotational axis of the expanding rivet is not 0°. In a particularly preferred embodiment, this angle is 90°.

Preferably, the opening in the panel comprises a circular hole, wherein the opening further has at least one recess radial to the circular hole, through which the second protrusion is inserted while inserting the expanding rivet through the opening in the panel and the expanding rivet is then rotated until the first protrusion intersects with and snaps into the recess of the opening in the panel in such a way, that the expanding rivet is held in a fixated manner relative to the panel by the second protrusion and the collar retaining the expanding rivet to the panel in the insertion direction and in the opposite direction and by the first protrusion sitting inside the recess retaining rotational movement of the expanding rivet. This embodiment is particularly suitable for the aforementioned embodiment of the expanding rivet and also allows the alternative use of the opening for other standardized fastening elements. Further, this way the expanding rivet is retained to the panel even in an unfastened state and hence can be preassembled with the panel to facilitate the assembly for the costumer.

Preferably, the expanding rivet has at least two recesses inside the collar of the expanding rivet. These recesses have an angle between their circumferential position in regard to the rotational axis of the expanding rivet of 180° and can be reached from the insertion direction to apply a tool to the two recesses to generate torque around the rotational axis of the expanding rivet. This way the expanding rivet can be assembled more easily, especially in regard to the aforementioned embodiment, where a rotation around the rotational axis of the expanding rivet is necessary for an easy assembly of the expanding rivet to the panel. In a particularly preferred embodiment, the recesses are formed in a way that a standard slotted screwdriver can be inserted into the recesses and can be used to apply torque onto the expanding rivet.

Preferably, the opening in the frame profile is non-circular.

Preferably, the opening in the frame profile is elongated in a first direction, and wherein after insertion, the expanding rivet is held in a nonrotatable manner relative to the panel and the frame profile, so that upon insertion of the expanding body the rivet legs are being forced apart in a direction perpendicular to the first direction. Thereby a particularly good retention of the expanding rivet on the frame profile can be achieved.

Preferably, the front surface of the panel has an indentation concentric to the opening in the panel, wherein the indentation is shaped in such a way, that the expanding rivet with the expanding body are flush with the front surface of the panel after insertion. This allows the cabinet to be placed directly against other vertical surfaces.

Preferably, the indentation is conical, wherein the expanding rivet has a conical collar for supporting the expanding rivet in the indentation, wherein the expanding body has a conical headpiece, and wherein the indentation and the collar are shaped in such a way, that in combination they act as countersink for receiving the headpiece of the expanding body. This ensures the proper alignment of the expanding rivet relative to the opening in the panel.

The present invention also provides a wiring cabinet with a panel, defined in independent claim 15, wherein the panel is mounted to the wiring cabinet by means of at least one fastening element, wherein the wiring cabinet comprises at least one frame profile. The panel has an upper end and a lower end, and has a rear surface and a front surface, wherein the panel is attached to the wiring cabinet, wherein the rear surface of the panel is in contact with the frame profile, and wherein the panel is fastened to the wiring cabinet by means of the fastening element. The fastening element is inserted through an opening in the panel and an opening in the frame profile, wherein the panel is held to the frame profile by the engagement of the fastening element with the frame profile. The fastening element comprises an expanding rivet with an opening, and further comprises an expanding body, wherein the expanding rivet has at least two rivet legs. The expanding rivet further is inserted from the front surface of the panel, wherein the expanding body is inserted into the opening of the expanding rivet, and wherein rivet legs are forced apart by the inserted expanding body in such a way, that the frame profile is engaged by the rivet legs. Thereby, the panel is preferably mounted to the wiring cabinet by a method according to one of the previous claims.

An example of the execution of this invention is explained in detail in the following drawings.
Figure 1 shows a wiring cabinet with a preferred embodiment of the method for attaching a panel to the wiring cabinet.
Figure 2 shows a compilation of a preferred embodiment of the method for fastening the panel to a frame profile of the wiring cabinet.
Figure 3 shows a detailed view of a preferred embodiment of an opening in the panel for receiving the fastening element.
Figure 4a shows a cross-section view of a preferred embodiment of a fastening element for fastening the panel.
Figure 4b shows a cross-section view of a preferred embodiment of a fastening element for fastening the panel, which is turned 90° around the rotational axis of the expanding rivet in regard to the cross-section view of Figure 4a.
Figure 5 shows a detailed view of a preferred embodiment of an opening in the frame profile for receiving the fastening element.
Figure 6 shows a detailed view of a preferred embodiment of a connection between the panel and a frame profile of the wiring cabinet.
Figure 7 shows a detailed 3D-view of a preferred embodiment of an expanding rivet.

For the following explanations, the same parts are designated by the same reference signs. If a Figure contains reference signs that are not described in more detail in the corresponding description of the Figure, reference is made to preceding or subsequent descriptions of the Figure.

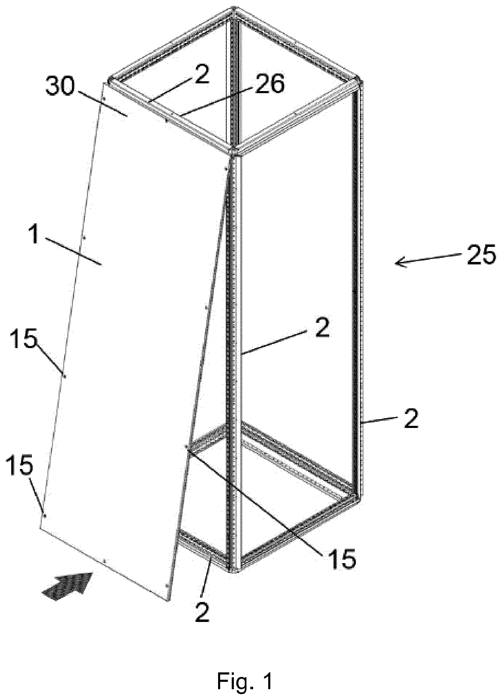

Figure 1 shows the panel 1 in the process of being attached to the wiring cabinet 25, which comprises several frame profiles 2. The panel 1 is thereby suspended at its upper end 30 from a horizontal frame element 26 and subsequently pivoted into a vertical orientation, which corresponds to the mounted position of the panel 1. The panel 1 further has several openings 14 for attaching the panel 1 to the frame profiles 2.

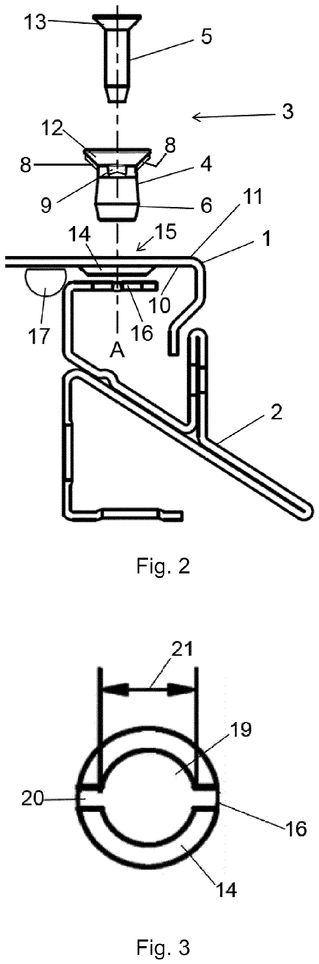

Figure 2 shows the fastening element 3 utilised for attaching the panel 1 to a frame profile 2 with the rear surface 10 of the panel 1 facing the frame profile 2. The fastening element 3 comprises an expanding rivet 4 and an expanding body 5 in the form of a screw. For fastening the panel 1 to a frame profile 2, the substantially round expanding rivet 4 is inserted through an opening in the panel 15, which is aligned with an opening in the frame profile 16, so that the expanding rivet 4 is also inserted through the frame opening 16.

The panel opening 15 is within a concentric conical indentation 14, which is shaped suitably to receive a conical collar 12 of the expanding rivet 4. The collar 12 thereby acts as countersink for receiving the conical headpiece 13 of the screw 5, so that in a completely mounted state the headpiece of the screw is flush with the front surface 11 of the panel 1.

By inserting the screw 5 into the expanding rivet 4, the rivet legs 6 are being forced apart in such a way, that the rivet legs 6 engage the frame profile 2, thereby retaining the panel 1 to the frame profile 2.

The panel 1 further has a gasket 17 installed along the edges of the panel 1, wherein the gasket 17 is being compressed against the frame profile 2 by fastening the panel 1 to the frame profile 2. The gasket 17 provides a sealing between the frame profile 2 and the panel 1.

The expanding rivet 4 has two radial first protrusions 8, which extend close to the outer edge of the collar 12 and have a face parallel to the conical indentation 14. The two first protrusions 8 have an angle between their circumferential positions in regard to the rotational axis of the expanding rivet 4 of 180°. Further, the expanding rivet 4 has two second protrusions 9, which also have an angle between their circumferential positions in regard to the rotational axis of the expanding rivet 4 of 180° and their positions are turned 90° around the rotational axis of the expanding rivet 4 in regard to the positions of the two first protrusions 8.

The panel opening 15, as shown in Figure 3, comprises a circular hole 19, which is concentric to the indentation 14, wherein the opening 15 further has two radial recesses 20 for passing through the second protrusions 9 and receiving the first protrusions 8. The radial recesses 20 thereby extend in a first direction 21 to the outer edge of the indentation 14. This way the second protrusions 9 can be passed through the radial recesses 20 and the expanding rivet 4 can then be rotated by a flat screwdriver, which is inserted into a slot drive incorporated in the conical collar 12 of the expanding rivet 4. Thereby the second protrusion 9 from the rear surface and the collar 12 from the front surface retain the expanding rivet in the insertion direction to the panel 1. The rotation of the expanding rivet is performed, until the first protrusions 8 snap into the radial recesses 20 to then hold the expanding rivet 4 in a nonrotatable manner relative to the panel 1. Hence, a fixation of the expanding rivet 4 relative to panel 1 is attained. For this fixation to be effective, the distance between the position of the first protrusion 8 to the second protrusion 9 alongside the insertion direction must be smaller then the thickness of the panel 1. Therefore, the material of the expanding rivet 4, the first protrusions 8 or the second protrusions 9 must be slightly flexible to allow the rotation and then fixation of the expanding rivet 4, while the first protrusions 8 are pressing against the front surface until the first protrusions 8 snap into the recesses 20 and the second protrusions 9 are pressing against the rear surface of the panel 1. Since the orientation of the panel 1 relative to the frame profile 2 is fixed as well, the expanding rivet 4 is also fixated relative to the frame profile 2.

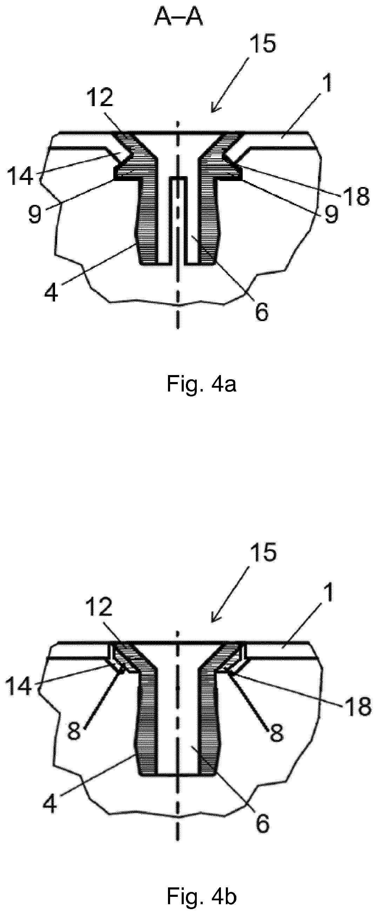

Figure 4a shows in detail the expanding rivet 4 with its two second protrusions 9, after it has been inserted through opening 15 and turned to its final position relative to panel 1. It shows a cross-sectional view of the expanding rivet 4 with the panel 1 along the section plane A shown in Figure 2. The second protrusions 9 thereby engage the panel 1, so that the expanding rivet 4 is retained to the panel 1. The second protrusions 9 thereby interlock with the inner edge 18 of the panel opening 15, whereby the edge 18 is tilted downwards by the indentation 14, thereby improving the grip of the second protrusions9. The expanding rivet 4 can therefore be inserted into the panel opening 15 before attaching the panel 1 to the wiring cabinet 25. Thereby, the expanding rivet 4 is securely retained to the panel 1 by the second protrusion 9 and the collar 12, and thus is subsequently inserted through the frame opening 16 upon attaching the panel 1 to the wiring cabinet 25.

Figure 4b shows in detail the expanding rivet 4 with its two first protrusions 8, after it has been inserted through opening 15 and turned to its final position relative to panel 1 and the first protrusions 8 have snapped into the radial recesses 20 of the opening 15. It shows a cross-sectional view of the expanding rivet 4 with the panel 1, which is turned 90° in regard to the cross-sectional view shown in Figure 4a. The first protrusions 8 sit inside the radial recesses 20 and are locked between the indentations 14 in the rotational direction of expanding rivet. Thereby, the expanding rivet 4 is retained nonrotable in regard to the panel 1.

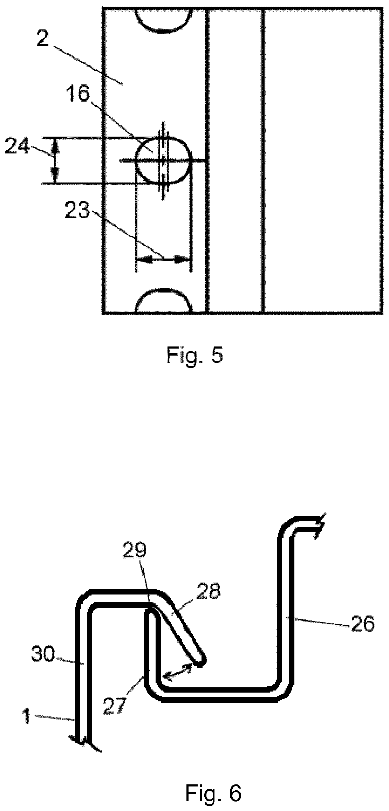

As shown in Figure 5, the frame opening 16 is non-circular, wherein the frame opening 16 is elongated in a first direction 23. The panel 1 is arranged so that the direction 21 of the recesses 20 corresponds to the first direction 23. Due to the interaction of the first protrusions 8 and the recesses 20, the expanding rivet 4 is aligned with respect to the frame opening 16 in such a way, that the rivet legs 6 upon insertion of the screw 5 are being forced apart in a second direction 24, which is orthogonal to the first direction 23, so that the rivet legs 6 expand beyond the width 24 of the frame opening.

As shown in Figure 6, the panel 1 at its upper end 30 has a first fold 28 for attaching the panel 1 to the wiring cabinet 25, which is formed in the shape of a hook, wherein the first fold 28 is hooked into a second fold 27 of the horizontal frame element 26, which is also formed in the shape of a hook, so that that the first fold 28 and the second fold 27 interact in the manner of a tilting mechanism 29. Upon suspending the panel 1 from the frame element 26, the panel 1 is therefore pivotable about the axis of the tilting mechanism 29, which is parallel to the frame element 26.

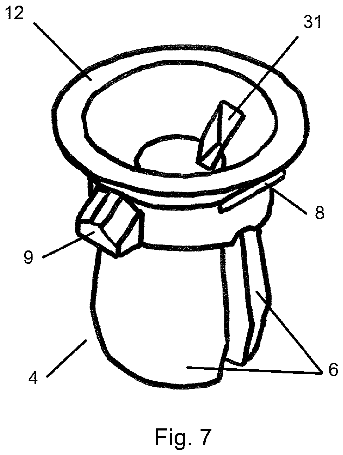

A detailed 3D-view of a preferred embodiment of the expanding rivet 4 is shown in Figure 7. The rivet legs 6 are positioned in the same direction as the second protrusions 9. Therefore, the frame profile 16 is also clamped between the lower face of the second protrusions 9 and the rivet legs 6, which enhances the grip of the expanding rivet onto the frame profile 16. Further, the top face of the second protrusions 9 is slightly angled down to facilitate the rotation of the expanding rivet 4, when the second protrusion 9 is starting to press against the indentation 14. The two recesses 31 for applying a tool to generate torque around the rotational axis of the expanding rivet inside the collar 12 of the expanding rivet 4 are located in the same circumferential direction from the rotational axis of the expanding rivet 4 as the two second protrusions 9, which gives more room for the recesses 31 inside the collar 12 due to the added material of the second protrusions 9. The first protrusions 8 are positioned perpendicular in regard to the rotational axis of the expanding rivet 4. This position facilitates the rotation of the expanding rivet, when the second protrusion 9 is pressing against the rear surface of the panel 1 and the first protrusion 8 is pressing against the front surface of the panel 1. The first protrusions 8 are formed with their lower face parallel to the collar 12. This further facilitates the rotation of the expanding rivet and lowers the necessary flexibility of either the first protrusions 8, the second protrusion 9 or the collar 12, which improves the fixation of the expanding rivet 4 to the panel 1, when the expanding rivet 4 is inserted and rotated to its final position in regard to the panel 1.

Instead of the expanding rivet being inserted from the front surface of the panel, the expanding rivet could also be clipped to the panel from its rear surface before subsequently attaching the panel to the wiring cabinet and subsequently inserting the expanding body into the rivet.

## Claims

1. Method for mounting a panel (1) to a wiring cabinet (25) using at least one fastening element (3), wherein the wiring cabinet (25) comprises at least one frame profile (2), wherein the panel (1) has an upper end (30) and a lower end, and wherein the panel (1) has a rear surface (10) and a front surface (11), the method comprising:
- attaching the panel (1) to the wiring cabinet (25) into a premounted state, wherein the rear surface (10) of the panel (1) is in contact with the frame profile (2);
- fastening the panel (1) to the wiring cabinet (25) by means of the fastening element (3), wherein the fastening element (3) is inserted through an opening in the panel (15) and an opening in the frame profile (16), and wherein the panel (1) is held to the frame profile (2) by the engagement of the fastening element (3) with the frame profile (2)
wherein the fastening element (3) comprises an expanding rivet (4) with an opening, and further comprises an expanding body (5), wherein the expanding rivet (4) has at least two rivet legs (6), wherein fastening the panel (1) comprises inserting the expanding rivet (4) in an insertion direction through the opening in the panel (15) and the opening in the frame profile (16), and inserting the expanding body (5) into the opening of the expanding rivet (4) so that the rivet legs (6) are forced apart in such a way, that the rivet legs (6) engage the frame profile (2),
**characterized in that** the expanding rivet (4) has at least one second protrusion (9), which protrudes radially from the expanding rivet (4), wherein the opening in the panel (15) comprises a circular hole that has at least one radial recess (20), through which the second protrusion (9) is inserted while inserting the expanding rivet (4) through the opening in the panel (15), wherein after insertion of the
expanding rivet (4) through the opening in the panel (15) and rotation around a rotational axis of the expanding rivet (4) the second protrusion (9) sits below the panel (1) and retains the expanding rivet (4) to the panel (1) in a direction opposite to the insertion direction..

2. Method according to claim **1,** wherein the expanding rivet (4) is being inserted from the front surface of the panel (11).

3. Method according to claim **1** or **2,** wherein the expanding body (5) is a screw.

4. Method according to one of the claims **1** to **3,** wherein attaching the panel to the wiring cabinet comprises suspending the panel at its upper end from a horizontal frame element in such a way that the panel in a premounted state is pivotable about an axis parallel to the horizontal frame element.

5. Method according to one of the claims **1** to **4,** wherein the expanding rivet (4) is round.

6. Method according to claims **1** to **5,** wherein the expanding rivet (4) has a collar (12) that radially protrudes beyond the circumference derived from the rivet legs (6), wherein the collar (12) sits on top of the front surface of the panel (11), when the expanding rivet (4) is inserted through the opening in the panel (15) and retains the expanding rivet (4) to the panel (1) in the insertion direction.

7. Method according to one of the claims **1** to **5,** wherein the opening in the panel (15) and the expanding rivet (4) are formed in such a way, that after insertion, the expanding rivet (4) is held in a nonrotatable manner relative to the panel (1).

8. Method according to claims **5** and **7,** wherein the expanding rivet (4) has at least one radial first protrusion (8), wherein the first protrusion (8) interacts with the opening in the panel (15) in such a way, that after insertion, the expanding rivet (4) is held in a nonrotatable manner relative to the panel (1).

9. Method according to claim **8**, wherein the first protrusion (8) and second protrusion (9) are positioned in a way that an angle between their circumferential positions with regard to the rotational axis of the expanding rivet (4) is not 0°, preferably is 90°.

10. Method according to claim **5** in combination with claim **9,** wherein after inserting the expanding rivet (4) through the opening in the panel (15) the expanding rivet (4) is then rotated until the first protrusion (8) intersects with and snaps into the recess of the opening (20) in the panel (1) in such a way, that the expanding rivet (4) is then held in a fixated manner relative to the panel (1) by the second protrusion (9) and the collar (12) retaining the expanding rivet (4) to the panel (1) in the insertion direction and in the opposite direction and by the first protrusion (8) sitting inside the recess (20) retaining rotational movement of the expanding rivet (4).

11. Method according to claim **10,** wherein the expanding rivet (4) has at least two recesses (31) inside the collar (12) of the expanding rivet (4), which have an angle between their circumferential position in regard to the rotational axis of the expanding rivet (4) of 180° and can be reached from the insertion direction to apply a tool to the two recesses (31) to generate torque around the rotational axis of the expanding rivet (4).

12. Method according to one of the claims **1** to **11,** wherein the opening in the frame profile (16) is non-circular.

13. Method according to one of the claims **7** to **8,** and according to claim **10,** wherein the opening in the frame profile (16) is elongated in a first direction (23), and wherein after insertion, the expanding rivet (4) is held in a nonrotatable manner relative to the panel (1) and the frame profile (2), so that upon insertion of the expanding body (5) the rivet legs (6) are being forced apart in a direction perpendicular to the first direction (23).

14. Method according to one of the claims **1** to **13,** wherein the front surface of the panel (11) has an indentation (14) concentric to the opening in the panel (15), wherein the indentation (14) is shaped in such a way, that the expanding rivet (4) with the expanding body (5) are flush with the front surface of the panel (11) after insertion.

15. Wiring cabinet (25) with a panel (1), wherein the panel (1) is mounted to the wiring cabinet (25) by means of at least one fastening element (3), wherein the wiring cabinet (25) comprises at least one frame profile (2), wherein the panel (1) has an upper end (30) and a lower end, and wherein the panel (1) has a rear surface (10) and a front surface (11), wherein the panel (1) is attached to the wiring cabinet (25), wherein the rear surface of the panel (10) is in contact with the frame profile (2), wherein the panel (1) is fastened to the wiring cabinet (25) by means of the fastening element (3), wherein the fastening element (3) is inserted through an opening in the panel (15) and an opening in the frame profile (16), and wherein the panel (1) is held to the frame profile (2) by the engagement of the fastening element (3) with the frame profile (2), the fastening element (3) comprises an expanding rivet (4) with an opening, and further comprises an expanding body (5), wherein the expanding rivet (4) has at least two rivet legs (6), wherein the expanding rivet (4) is inserted from the front surface of the panel (11) through an opening in the panel (15), wherein the expanding body (5) is inserted into the opening of the expanding rivet (4), and wherein rivet legs (6) are forced apart by the inserted expanding body (5) in such a way, that the frame profile (2) is engaged by the rivet legs (6), **characterized in that** the expanding rivet (4) has at least one second protrusion (9), which protrudes radially from the expanding rivet (4), wherein the opening in the panel (15) comprises a circular hole that has at least one radial recess (20), through which the second protrusion (9) is inserted while inserting the expanding rivet (4) through the opening in the panel (15), wherein after insertion of the expanding rivet (4) through the opening in the panel (15) and rotation around a rotational axis of the expanding rivet (4), the second protrusion (9) sits below the panel (1) and retains the expanding rivet (4) to the panel (1) in a direction opposite to the insertion direction.

16. Wiring cabinet (25) according to claim **15, characterised in that** the expanding rivet (4) is round, has retaining elements, which fixate the expanding rivet (4) after insertion through the opening in the panel (15) in the insertion direction and in the opposite direction and retain rotational movement of the expanding rivet (4) around the rotational axis of the expanding rivet (4) in regard to the panel (1) and has at least two recesses (31) inside the collar (12) of the expanding rivet (4), which have an angle between their circumferential positions in regard to the rotational axis of the expanding rivet (4) of 180°, wherein the recesses (31) can be reached from the insertion direction to apply a tool to the two recesses (31) to generate torque around the rotational axis of the expanding rivet (4).

## Patentansprüche

1. Verfahren zum Montieren einer Platte (1) an einem Kabelschrank (25) unter Verwendung wenigstens eines Befestigungselementes (3), wobei der Kabelschrank (25) wenigstens ein Rahmenprofil (2) umfasst, die Platte (1) ein oberes Ende (30) sowie ein unteres Ende hat, die Platte (1) eine Rückseite (10) sowie eine Vorderseite (11) hat und das Verfahren umfasst:
- Anbringen der Platte (1) an dem Kabelschrank (25) in einem vormontierten Zustand, wobei die Rückseite (10) der Platte (1) in Kontakt mit dem Rahmenprofil (2) ist;
- Befestigen der Platte (1) an dem Kabelschrank (25) mittels des Befestigungselementes (3), wobei das Befestigungselement (3) über eine Öffnung in der Platte (15) sowie eine Öffnung in dem Rahmenprofil (16) eingeführt wird, und die Platte (1) durch den Eingriff des Befestigungselementes (3) mit dem Rahmenprofil (2) an dem Rahmenprofil (2) gehalten wird
wobei das Befestigungselement (3) einen Spreizniet (4) mit einer Öffnung umfasst und des Weiteren einen Spreizkörper (5) umfasst, der Spreizniet (4) wenigstens zwei Nietschenkel (6) aufweist, Befestigen der Platte (1) umfasst, dass der Spreizniet (4) in einer Einführungsrichtung über die Öffnung in der Platte (15) und die Öffnung in dem Rahmenprofil (16) eingeführt wird, und der Spreizkörper (5) so in die Öffnung des Spreizniets (4) eingeführt wird, dass die Nietschenkel (6) so auseinander gedrückt werden, dass die Nietschenkel (6) mit dem Rahmenprofil (2) in Eingriff kommen,
**dadurch gekennzeichnet, dass** der Spreizniet (4) wenigstens einen zweiten Vorsprung (9) aufweist, der radial von dem Spreizniet (4) vorsteht, wobei die Öffnung in der Platte (15) ein kreisförmiges Loch umfasst, das wenigstens eine radiale Aussparung (20) aufweist, über die der zweite Vorsprung (9) eingeführt wird, während der Spreizniet (4) über die Öffnung in der Platte (15) eingeführt wird, wobei nach Einführung des Spreizniets (4) über die Öffnung in der Platte (15) und Drehung um eine Drehachse des Spreizniets (4) herum der zweite Vorsprung (9) unter der Platte (1) sitzt und den Spreizniet (4) in einer Richtung entgegengesetzt zu der Einführungsrichtung an der Platte (1) hält.

2. Verfahren nach Anspruch 1, wobei der Spreizniet (4) von der Vorderseite der Platte (11) her eingeführt wird.

3. Verfahren nach Anspruch 1 oder 2, wobei der Spreizkörper (5) eine Schraube ist.

4. Verfahren nach einem der Ansprüche 1 bis 3, wobei Anbringen der Platte an dem Kabelschrank umfasst, dass die Platte an ihrem oberen Ende an einem horizontalen Rahmenelement so aufgehängt wird, dass die Platte in einem vormontierten Zustand um eine Achse parallel zu dem horizontalen Rahmenelement geschwenkt werden kann.

5. Verfahren nach einem der Ansprüche 1 bis 4, wobei der Spreizniet (4) rund ist.

6. Verfahren nach einem der Ansprüche 1 bis 5, wobei der Spreizniet (4) einen Bund (12) aufweist, der radial über den von den Nietschenkeln (6) ausgehenden Umfang hinaus vorsteht, wobei der Bund (12) auf der Vorderseite der Platte (11) aufsitzt, wenn der Spreizniet (4) über die Öffnung in der Platte (15) eingeführt wird, und den Spreizniet (4) in der Einführrichtung an der Platte (1) hält.

7. Verfahren nach einem der Ansprüche 1 bis 5, wobei die Öffnung in der Platte (15) und der Spreizniet (4) so ausgebildet sind, dass der Spreizniet (4) nach Einführung so gehalten wird, dass er relativ zu der Platte (1) nicht gedreht werden kann.

8. Verfahren nach den Ansprüchen 5 und 7, wobei der Spreizniet (4) wenigstens einen radialen ersten Vorsprung (8) aufweist, der erste Vorsprung (8) mit der Öffnung in der Platte (15) so in Wechselwirkung ist, dass der Spreizniet (4) nach Einführung so gehalten wird, dass er relativ zu der Platte (1) nicht gedreht werden kann.

9. Verfahren nach Anspruch 8, wobei der erste Vorsprung (8) und der zweite Vorsprung (9) so positioniert sind, dass ein Winkel zwischen ihren Umfangspositionen in Bezug auf die Drehachse des Spreizniets (4) nicht 0°, vorzugsweise 90°, beträgt.

10. Verfahren nach Anspruch 5 in Verbindung mit Anspruch 9, wobei nach Einführen des Spreizniets (4) über die Öffnung in der Platte (15) der Spreizniet (4) dann gedreht wird, bis der erste Vorsprung (8) die Aussparung der Öffnung (20) in der Platte (1) schneidet und so einrastet, dass der Spreizniet (4) dann durch den zweiten Vorsprung (9) und den Bund (12), der den Spreizniet (4) an der Platte (1) in der Einführungsrichtung und in der entgegengesetzten Richtung hält, sowie durch den ersten Vorsprung (8), der im Inneren der Aussparung (20) sitzt und Drehbewegung des Spreizniets (4) hemmt, relativ zu der Platte (1) fixierend gehalten wird.

11. Verfahren nach Anspruch 10, wobei der Spreizniet (4) im Inneren des Bundes (12) des Spreizniets (4) wenigstens zwei Aussparungen (31) aufweist, die einen Winkel von 180° zwischen ihrer Umfangsposition in Bezug auf die Drehachse des Spreizniets (4) aufweisen und aus der Einführungsrichtung erreicht werden können, um ein Werkzeug in die zwei Aussparungen (31) einzubringen und Drehmoment um die Drehachse des Spreizniets (4) herum zu erzeugen.

12. Verfahren nach einem der Ansprüche 1 bis 11, wobei die Öffnung in dem Rahmenprofil (16) nicht kreisförmig ist.

13. Verfahren nach einem der Ansprüche 7 bis 8 und nach Anspruch 10, wobei die Öffnung in dem Rahmenprofil (16) in einer ersten Richtung (23) gestreckt ist, und der Spreizniet (4) nach Einführung relativ zu der Platte (1) und zu dem Rahmenprofil (2) so gehalten wird, dass er nicht gedreht werden kann, so dass bei Einführung des Spreizkörpers (5) die Nietschenkel (6) in einer Richtung senkrecht zu der ersten Richtung (23) auseinander gedrückt werden.

14. Verfahren nach einem der Ansprüche 1 bis 13, wobei die Vorderseite der Platte (11) eine zu der Öffnung in der Platte (15) konzentrische Vertiefung (14) aufweist und die Vertiefung (14) so geformt ist, dass der Spreizniet (4) mit dem Spreizkörper (5) nach Einführung bündig mit der Vorderseite der Platte (11) ist.

15. Kabelschrank (25) mit einer Platte (1), wobei die Platte (1) mittels wenigstens eines Befestigungselementes (3) an dem Kabelschrank (25) befestigt ist, der Kabelschrank (25) wenigstens ein Rahmenprofil (2) umfasst, die Platte (1) ein oberes Ende (30) und ein unteres Ende aufweist, die Platte (1) eine Rückseite (10) und eine Vorderseite (11) hat, die Platte (1) an dem Kabelschrank (25) angebracht ist, die Rückseite der Platte (10) in Kontakt mit dem Rahmenprofil (2) ist, die Platte (1) an dem Kabelschrank (25) mittels des Befestigungselementes (3) befestigt ist, das Befestigungselement (3) über eine Öffnung in der Platte (15) sowie eine Öffnung in dem Rahmenprofil (16) eingeführt ist, und die Platte (1) durch den Eingriff des Befestigungselementes (3) mit dem Rahmenprofil (2) an dem Rahmenprofil (2) gehalten wird,
das Befestigungselement (3) einen Spreizniet (4) mit einer Öffnung umfasst und des Weiteren einen Spreizkörper (5) umfasst, wobei der Spreizniet (4) wenigstens zwei Nietschenkel (6) aufweist, der Spreizniet (4) von der Vorderseite der Platte (11) her über eine Öffnung in der Platte (15) eingeführt wird, der Spreizkörper (5) in die Öffnung des Spreizniets (4) eingeführt wird und die Nietschenkel (6) durch den eingeführten Spreizkörper (5) so auseinander gedrückt werden, dass das Rahmenprofil (2) mit den Nietschenkeln (6) in Eingriff kommt, **dadurch gekennzeichnet, dass** der Spreizniet (4) wenigstens einen zweiten Vorsprung (9) aufweist, der radial von dem Spreizniet (4) vorsteht, die Öffnung in der Platte (15) ein kreisförmiges Loch umfasst, das wenigstens eine radiale Aussparung (20) aufweist, über die der zweite Vorsprung (9) eingeführt wird, während der Spreizniet (4) über die Öffnung in der Platte (15) eingeführt wird, wobei nach Einführung des Spreizniets (4) über die Öffnung in der Platte (15) sowie Drehung um eine Drehachse des Spreizniets (4) herum der zweite Vorsprung (9) unter der Platte (1) sitzt und den Spreizniet (4) in einer Richtung entgegengesetzt zu der Einführungsrichtung an der Platte (1) hält.

16. Kabelschrank (25) nach Anspruch 15, **dadurch gekennzeichnet, dass** der Spreizniet (4) rund ist, Halteelemente aufweist, die den Spreizniet (4) nach Einführung über die Öffnung in der Platte (15) in der Einführungsrichtung sowie in der entgegengesetzten Richtung fixieren und Drehbewegung des Spreizniets (4) um die Drehachse des Spreizniets (4) herum in Bezug auf die Platte (1) hemmen und wenigstens zwei Aussparungen (31) im Inneren des Bundes (12) des Spreizniets (4) aufweist, die einen Winkel von 180° zwischen ihren Umfangspositionen in Bezug auf die Drehachse des Spreizniets (4) aufweisen, wobei die Aussparungen (31) aus der Einführrichtung erreicht werden können, um ein Werkzeug in die beiden Aussparungen (31) einzubringen und Drehmoment um die Drehachse des Spreizniets (4) herum zu erzeugen.

## Revendications

1. Procédé de montage d'un panneau (1) sur une armoire de câblage (25) en utilisant au moins un élément de fixation (3), l'armoire de câblage (25) comprenant au moins un profil de châssis (2), le panneau (1) possédant une extrémité supérieure (30) et une extrémité inférieure, et le panneau (1) possédant une surface arrière (10) et une surface avant (11), le procédé comprenant :
- L'installation du panneau (1) sur l'armoire de câblage (25) dans un état de pré montage, la surface arrière (10) du panneau (1) étant en contact avec le profil de châssis (2),
- la fixation du panneau (1) à l'armoire de câblage (25) au moyen de l'élément de fixation (3), l'élément de fixation (3) étant inséré au travers d'une ouverture (15) pratiquée dans le panneau et d'une ouverture (16) pratiquée dans le profil de châssis, le panneau (1) étant maintenu sur le profil de châssis (2) par la mise en prise de l'élément de fixation (3) avec le profil de châssis (2),
dans lequel l'élément de fixation (3) comprend un rivet à expansion (4) comportant une ouverture, et il comprend en outre un corps à expansion (5), le rivet à expansion (4) possédant au moins deux pattes de rivet (6), la fixation du panneau (1) comprenant l'insertion du rivet à expansion (4) dans une direction d'insertion au travers de l'ouverture (15) dans le panneau et de l'ouverture (16) dans le profil de châssis, ainsi que l'insertion du corps à expansion (5) dans l'ouverture du rivet à expansion (4) de sorte à ce que les pattes de rivet (6) soit écartées à force pour que les pattes de rivet (6) se mettent en prise avec le profil de châssis (2),
**caractérisé en ce que** le rivet à expansion (4) possède au moins une seconde protubérance (9) qui dépasse radialement du rivet à expansion (4), l'ouverture (15) dans le panneau comprenant un trou circulaire qui comporte au moins un évidement radial (100) au travers duquel est insérée la seconde protubérance (9) lors de l'insertion du rivet à expansion (4) au travers de l'ouverture (15) dans le panneau, où, après l'insertion du rivet à expansion (4) au travers de l'ouverture (15) dans le panneau et après une rotation autour d'un axe de rotation du rivet à expansion (4), la seconde protubérance (9) se trouve en dessous du panneau (1) et retient le rivet à expansion (4) sur le panneau (1) dans la direction opposée à la direction d'insertion.

2. Procédé selon la revendication **1,** dans lequel le rivet à expansion (4) est inséré depuis la surface avant du panneau (11).

3. Procédé selon la revendication **1** ou la revendication **2,** dans lequel le corps à expansion (5) est une vis.

4. Procédé selon l'une des revendications **1** à **3,** dans lequel la fixation du panneau au cabinet de câblage comprend la suspension du panneau au niveau de son extrémité supérieure depuis un élément de châssis horizontal de manière à ce que le panneau à l'état de pré montage puisse pivoter autour d'un axe parallèle à l'élément de châssis horizontal.

5. Procédé selon l'une des revendications **1** à **4,** dans lequel le rivet à expansion (4) est rond.

6. Procédé selon l'une des revendications **1** à **5,** dans lequel le rivet à expansion (4) possède un collier (12) qui dépasse radialement au-delà de la circonférence résultant des pattes de rivet (6), le collier (12) se trouvant au sommet de la surface avant du panneau (11) lorsque le rivet à expansion (4) est inséré au travers de l'ouverture (15) dans le panneau et retient le rivet à expansion (4) au panneau (1) dans la direction d'insertion.

7. Procédé selon l'une des revendications **1** à **5,** dans lequel l'ouverture (15) dans le panneau et le rivet à expansion (4) sont formés de manière à ce qu'après l'insertion, le rivet à expansion (4) soit maintenu de façon à ne pas pouvoir tourner par rapport au panneau (1).

8. Procédé selon les revendications **5** et **7,** dans lequel le rivet à expansion (4) possède au moins une première protubérance (8) radiale, la première protubérance (8) interagissant avec l'ouverture (15) dans le panneau de manière à ce qu'après l'insertion, le rivet à expansion (4) soit maintenu de façon à ne pas pouvoir tourner par rapport au panneau (1).

9. Procédé selon la revendication **8,** dans lequel la première protubérance (8) et la seconde protubérance (9) sont positionnées de manière à ce que l'angle entre leurs positions circonférentielles par rapport à l'axe de rotation du rivet à expansion (4) ne soit pas 0 ° mais de préférence 90 °.

10. Procédé selon la revendication **5** en combinaison avec la revendication **9,** dans lequel, après l'insertion du rivet à expansion (4) au travers de l'ouverture (15) dans le panneau, le rivet à expansion (4) soit ensuite tourné jusqu'à ce que la première protubérance (8) coupe l'évidement de l'ouverture (20) dans le panneau (1) et s'encliquette avec celui-ci de manière à ce que le rivet à expansion (4) soit ensuite maintenu fixe par rapport au panneau (1) par la seconde protubérance (9) et par le collier (12) qui retient le rivet à expansion (4) au panneau (1) dans la direction d'insertion et dans la direction opposée, et par la première protubérance (8) qui se trouve à l'intérieur de l'évidement (20) limitant tout mouvement de rotation du rivet à expansion (4) .

11. Procédé selon la revendication **10,** dans lequel le rivet à expansion (4) comporte au moins deux évidements (31) à l'intérieur du collier (12) du rivet à expansion (4) qui présentent un angle de 180 entre leurs positions circonférentielles par rapport à l'axe de rotation du rivet à expansion (4) et peuvent être atteints depuis la direction d'insertion pour appliquer un outil sur les deux évidements (31) dans le but de générer un couple autour de l'axe de rotation du rivet à expansion (4).

12. Procédé selon l'une des revendications **1** à **11,** dans lequel l'ouverture (16) dans le profil de châssis n'est pas circulaire.

13. Procédé selon l'une des revendications **7** à **8,** dans lequel l'ouverture (16) dans le profil de châssis est allongée dans une première direction (23), et où, après l'insertion, le rivet à expansion (4) est maintenu pour ne pas pouvoir tourner par rapport au panneau (1) et au profil de châssis (2) de telle sorte que lors de l'insertion du corps à expansion (5), les pattes de rivet (6) sont écartées de force dans une direction perpendiculaire à la première direction (23).

14. Procédé selon l'une des revendications **1** à **13,** dans lequel la surface avant du panneau (11) présente une indentation (14) concentrique à l'ouverture (15) dans le panneau, l'indentation (14) présentant une forme telle que le rivet à expansion (4) avec le corps à expansion (5) sont de niveau avec la surface avant du panneau (11) après l'insertion.

15. Cabinet de câblage (25) avec un panneau (1), le panneau (1) étant monté sur le cabinet de câblage (25) au moyen d'au moins un élément de fixation (3), l'armoire de câblage (25) comprenant au moins un profil de châssis (2), le panneau (1) possédant une extrémité supérieure (30) et une extrémité inférieure, et le panneau (1) possédant une surface arrière (10) et une surface avant (11), le panneau (1) étant fixé à l'armoire de câblage (25), la surface arrière du panneau (10) étant en contact avec le profil de châssis (2), le panneau (1) étant fixé sur l'armoire de câblage au moyen de l'élément de fixation (3), l'élément de fixation (3) étant inséré au travers d'une ouverture (15) pratiquée dans le panneau et au travers d'une ouverture (16) pratiquée dans le profil de châssis, et le panneau (1) étant maintenu sur le profil de châssis (2) grâce à la mise en prise de l'élément de fixation (3) avec le profil de châssis (2),
l'élément de fixation (3) comprend un rivet à expansion (4) comportant une ouverture, et il comprend en outre un corps à expansion (5), le rivet à expansion (4) possédant au moins deux pattes de rivet (6), le rivet à expansion (4) étant inséré depuis la surface avant (11) du panneau au travers d'une ouverture (15) dans le panneau, le corps à expansion (5) étant inséré dans l'ouverture du rivet à expansion (4), et les pattes de rivet (6) étant écartées à force par le corps à expansion (5) inséré de manière à ce que le profil de châssis (2) soit en prise grâce aux pattes de rivet (6), **caractérisé en ce que** le rivet à expansion (4) possède au moins une seconde protubérance (9) qui dépasse radialement du rivet à expansion (4), l'ouverture (15) dans le panneau comprenant un trou circulaire qui comporte au moins un évidement radial (100) au travers duquel est insérée la seconde protubérance (9) lors de l'insertion du rivet à expansion (4) au travers de l'ouverture (15) dans le panneau, où, après l'insertion du rivet à expansion (4) au travers de l'ouverture (15) dans le panneau et après une rotation autour d'un axe de rotation du rivet à expansion (4), la seconde protubérance (9) se trouve en dessous du panneau (1) et retient le rivet à expansion (4) sur le panneau (1) dans la direction opposée à la direction d'insertion.

16. Cabinet de câblage (25) selon la revendication **15, caractérisé en ce que** le rivet à expansion (4) est rond, comporte des éléments de retenue qui fixent le rivet à expansion (4) après l'insertion au travers de l'ouverture (15) dans le panneau dans la direction d'insertion et dans la direction opposée et qui limitent tout mouvement de rotation du rivet à expansion (4) autour de l'axe de rotation du rivet à expansion (4) par rapport au panneau (1), et il possède au moins deux évidements (31) à l'intérieur du collier (12) du rivet à expansion (4) qui présentent un angle de 180 ° par rapport à l'axe de rotation du rivet à expansion (4), les évidements (31) pouvant être atteints depuis la direction d'insertion dans le but d'appliquer un outil sur les deux évidements (31) pour générer un couple autour de l'axe de rotation du rivet à expansion (4).
